# EUROPÄISCHE PATENTSCHRIFT

(11) **EP 1 649 298 B1**
(45) Veröffentlichungstag und Bekanntmachung des Hinweises auf die Patenterteilung: **28.05.2008**
(21) Anmeldenummer: 04766260.6
(22) Anmeldetag: 19.07.2004
(51) Int. Cl.: G01R 31/00, G01R 31/319

(54) **VERFAHREN ZUR DIAGNOSE VON TREIBERAUSGÄNGEN UND DIAGNOSEPULSMANAGER**
METHOD FOR THE DIAGNOSIS OF DRIVER OUTPUTS AND DIAGNOSIS PULSE MANAGER
PROCEDE POUR LE DIAGNOSTIC DE SORTIES DE CIRCUIT D'ATTAQUE ET GESTIONNAIRE D'IMPULSIONS DE DIAGNOSTIC

(30) Priorität: 31.07.2003 DE 10335135
(43) Veröffentlichungstag der Anmeldung: 26.04.2006
(73) Patentinhaber: Continental Automotive GmbH, 30165 Hannover (DE)
(72) Erfinder: THIVEOS, Konstantin, 82418 Murnau (DE); LÄUFER, Andreas, 93047 Regensburg (DE)
(86) Internationale Anmeldenummer: PCT/EP2004/051541
(87) Internationale Veröffentlichungsnummer: WO 2005/012929

(56) Entgegenhaltungen:
- US-A- 4 873 452
- US-A- 5 063 516
- IBM TECHNICAL DISCLOSURE BULLETIN, Bd. 27, Nr. 3, August 1984 (1984-08), Seiten 1784-1786, XP002304699

## Beschreibung

Die Erfindung betrifft ein Verfahren zur Diagnose von Treiberausgängen, insbesondere zum Einsatz in einem Kraftfahrzeug, bei dem zum Auslesen eines Diagnoseergebnisses an einem Treiberausgang dem Treiberausgang ein Puls zugeführt wird.

Die Erfindung betrifft weiterhin einen Diagnosepulsmanager zum Zuführen von Pulsen zu Treiberausgängen in Abhängigkeit von Systemanforderungen, insbesondere zum Einsatz in einem Kraftfahrzeug, um an Treiberausgängen Diagnoseergebnisse auszulesen.

Es ist bekannt, Endstufentreiberausgänge im Rahmen einer Fehlerdiagnose heim Betrieb eines Kraftfahrzeugs zu überwachen. Um in gewissen Schaltzuständen eindeutige Diagnoseergebnisse zu erhalten, ist es notwendig, einem Endstufentreiberausgang aktiv einen Puls zuzuführen. Die Zuführung eines solchen Pulses wird vom System angefordert.

In diesem Zusammenhang ist es problematisch, wenn für mehrere Treiberausgänge gleichzeitig die Anforderung eines Pulses vorliegt, insbesondere dann, wenn aus Systemgründen nicht gleichzeitig für alle Treiberausgänge ein Puls zur Verfügung gestellt werden kann. Dies ist beispielsweise dann der Fall, wenn das System nur eine Timerfunktionalität zur Verfügung stellt.

Die US 4,873,452 beschreibt ein Beispiel für das Zuführen von Diagnosepulsen zu einem Treiberausgang. Bei diesem Beispiel weist ein Aufpralldetektor einen Diagnosepulsgenerator auf, der einem Beschleunigungssensor Diagnosepulse zuführt. Auf diese Weise soll festgestellt werden, ob der Beschleunigungssensor eventuell ein Fehlverhalten zeigt.

Der Erfindung liegt die Aufgabe zugrunde, ein Verfahren und einen Diagnosepulsmanager zur Verfügung zu stellen, so dass bei gleichzeitiger Anforderung von Pulsen für mehrere Treiberausgänge eine zuverlässige Fehlerdiagnose erfolgen kann. Diese Aufgabe wird mit den Merkmalen der unabhängigen Ansprüche gelöst.

Vorteilhafte Ausführungsformen der Erfindung sind in den abhängigen Ansprüchen angegeben.

Die Erfindung baut auf dem gattungsgemäßen Verfahren dadurch auf, dass eine für einen Treiberausgang bestehende Anforderung eines Pulses gespeichert werden kann, wobei insbesondere mehrere gleichzeitig bestehende Anforderungen gespeichert werden können, und dass mehrere gespeicherte Anforderungen gemäß vorgegebener Regeln nacheinander berücksichtigt werden. Liegen somit mehrere Anforderungen für Pulse vor, so ist es nicht erforderlich, nur eine dieser Anforderungen willkürlich zu berücksichtigen und die anderen Anforderungen zu verwerfen. Vielmehr können die Anforderungen gespeichert werden und nachfolgend gemäß vorgegebener Regeln nacheinander berücksichtigt werden.

Das Verfahren ist in vorteilhafter Weise dadurch weitergebildet, dass die Anforderungen in einem Diagnosepulsanforderungsregister als binäre Werte gespeichert werden können, dass die in dem Diagnosepulsanforderungsregister gespeicherten Anforderungen in ein Diagnosepulsausführungsregister übertragen werden können und dass das Diagnosepulsanforderungsregister nach dem Übertragen der Anforderungen in das Diagnosepulsausführungsregister gelöscht wird. Die Systemanforderungen können somit zunächst in einem Diagnosepulsanforderungsregister gespeichert werden und dann in Abhängigkeit von Vorgängen in der Vergangenheit beziehungsweise von sonstigen Kriterien gegebenenfalls in ein Diagnosepulsausführungsregister überführt werden. Nach Überführung der Information kann das Diagnosepulsanforderungsregister gelöscht werden, um so in einem nächsten Zyklus neue Systemanforderungen berücksichtigen zu können.

Nützlicherweise ist vorgesehen, dass das Übertragen der Anforderungen von dem Diagnosepulsanforderungsregister in das Diagnosepulsausführungsregister nur dann erfolgt, wenn in dem Diagnosepulsausführungsregister keine Anforderungen gespeichert sind. Andernfalls wird zunächst eine im Diagnosepulsausführungsregister gespeicherte Anforderung, die als nächste auszuführen ist, in einen an dem zugeordneten Treiberausgang auszuführenden Puls umgesetzt.

Weiterhin ist nützlich, dass vor dem Übertragen der Anforderungen von dem Diagnosepulsanforderungsregister in das Diagnosepulsausführungsregister in dem Diagnosepulsanforderungsregister nicht mehr gespeicherte Anforderungen ebenfalls in dem Diagnosepulsausführungsregister gelöscht werden. Auf diese Weise wird berücksichtigt, ob Bedingungen, die in der Vergangenheit einmal vorgelegen haben, nach wie vor bestehen; nur wenn dies der Fall ist, kommt eine Ausführung der Pulse am entsprechenden Treiberausgang in Frage.

Die Erfindung ist in vorteilhafter Weise dadurch weitergebildet, dass nach dem Berücksichtigen einer in dem Diagnosepulsausführungsregister gespeicherten Anforderung diese Anforderung in dem Diagnosepulsausführungsregister gelöscht wird. Bei einer nachfolgenden Abfrage des Diagnosepulsausführungsregisters können somit anderen Treiberausgängen zugeordnete Diagnosepulse ausgeführt werden, sofern entsprechende Anforderungen im Diagnosepulsausführungsregister gespeichert sind.

Es ist bevorzugt, dass die vorgegebenen Regeln auf mindestens einem der folgenden Kriterien beruhen: verschiedene Treiberausgänge haben unterschiedliche Priorität, und eine einem bestimmten Treiberausgang zugeordnete Anforderung darf berücksichtigt werden oder nicht. Im Falle der Berücksichtigung unterschiedlicher Prioritäten werden die Anforderungen zuerst berücksichtigt, die Treiberausgängen höherer Priorität zugeordnet sind. Beispielsweise kann vorgesehen sein, dass die Treiberkanäle in der Reihenfolge ihrer Ordnungszahl priorisiert sind. Im Falle des anderen Kriteriums, dass eine einem bestimmten Treiberausgang zugeordnete Anforderung berücksichtigt werden darf oder nicht, kann vorgesehen sein, in Abhängigkeit sonstiger Voraussetzungen bestimmte Treiberausgänge vollständig von der Beaufschlagung mit angeforderten Pulsen auszunehmen.

Es ist nützlicherweise vorgesehen, dass die Prioritäten der Treiberausgänge durch Konfiguration einer Steuerungs- und Priorisierungseinheit festgelegt werden. Diese kann beispielsweise beeinflussen, ob Stellen in den Registern tatsächlich beschrieben oder gelöscht werden sollen.

Insbesondere ist von Vorteil, dass sich die Prioritäten der Treiberausgänge dynamisch in Abhängigkeit von Betriebszuständen des Kraftfahrzeugs ändern. Beispielsweise kann bei hohen Drehzahlen die Auswertung bestimmter Treiberausgänge besonders sinnvoll sein, die andererseits bei niedrigen Drehzahlen nur von untergeordnetem Interesse sind.

Die Erfindung baut auf dem gattungsgemäßen Diagnosepulsmanager dadurch auf, dass ein Diagnosepulsanforderungsregister zum Speichern einer für einen Treiberausgang bestehenden Anforderung eines Pulses vorgesehen ist, wobei insbesondere mehrere gleichzeitig bestehende Anforderungen gespeichert werden können, und dass mehrere gespeicherte Anforderungen gemäß vorgegebener Regeln nacheinander berücksichtigt werden können. Auf diese Weise werden die Vorteile und Besonderheiten des erfindungsgemäßen Verfahrens auch im Rahmen eines Diagnosepulsmanagers umgesetzt. Dies gilt auch für die nachfolgend angegebenen besonders bevorzugten Ausführungsformen des erfindungsgemäßen Diagnosepulsanforderungsmanagers.

Dieser ist in nützlicher Weise dadurch weitergebildet, dass die Anforderungen in dem Diagnosepulsanforderungsregister als binäre Werte gespeichert werden können, dass die in dem Diagnosepulsanforderungsregister gespeicherten Anforderungen in ein Diagnosepulsausführungsregister übertragen werden können und dass das Diagnosepulsanforderungsregister nach dem Übertragen der Anforderungen in das Diagnosepulsausführungsregister gelöscht wird.

Weiterhin ist vorgesehen, dass das Übertragen der Anforderungen von dem Diagnosepulsanforderungsregister in das Diagnosepulsausführungsregister nur dann erfolgt, wenn in dem Diagnosepulsausführungsregister keine Anforderungen gespeichert sind.

Insbesondere ist von Vorteil, dass vor dem Übertragen der Anforderungen von dem Diagnosepulsanforderungsregister in das Diagnosepulsausführungsregister in dem Diagnosepulsanforderungsregister nicht mehr gespeicherte Anforderungen ebenfalls in dem Diagnosepulsausführungsregister gelöscht werden.

Vorzugsweise ist auch vorgesehen, dass nach dem Berücksichtigen einer in dem Diagnosepulsausführungsregister gespeicherten Anforderung diese Anforderung in dem Diagnosepulsausführungsregister gelöscht wird.

Bei dem Diagnosepulsmanager ist es besonders bevorzugt, dass die vorgegebenen Regeln auf mindestens einem der folgenden Kriterien beruhen: verschiedene Treiberausgänge haben unterschiedliche Priorität, und eine einem bestimmten Treiberausgang zugeordnete Anforderung darf berücksichtigt werden oder nicht.

Hierbei ist weiterhin vorgesehen, dass die Prioritäten der Treiberausgänge durch Konfiguration einer Steuerungs- und Priorisierungseinheit festgelegt werden.

Der erfindungsgemäße Diagnosepulsmanager ist in vorteilhafter Weise dadurch weitergebildet, dass sich die Prioritäten der Treiberausgänge dynamisch in Abhängigkeit von Betriebszuständen des Kraftfahrzeugs ändern.

Der Erfindung liegt die Erkenntnis zugrunde, dass bei gleichzeitiger Anforderung von Pulsen für mehrere Treiberausgänge gewährleistet werden kann, dass alle Pulsanforderungen in einem Diagnosepulsmanager verarbeitet werden. Insbesondere können dabei Priorisierungsregeln und Steuerungsalgorithmen berücksichtigt werden.

Die Erfindung wird nun mit Bezug auf die begleitenden Zeichnungen anhand bevorzugter Ausführungsformen beispielhaft erläutert.

Dabei zeigt:
- Figur 1: ein Funktionsblockdiagramm zur Erläuterung der vorliegenden Erfindung;
- Figur 2: ein Flussdiagramm zur Erläuterung eines erfindungsgemäßen Verfahrens; und
- Figur 3: ein Diagramm zur beispielhaften Erläuterung des Flussdiagramms gemäß Figur 2.

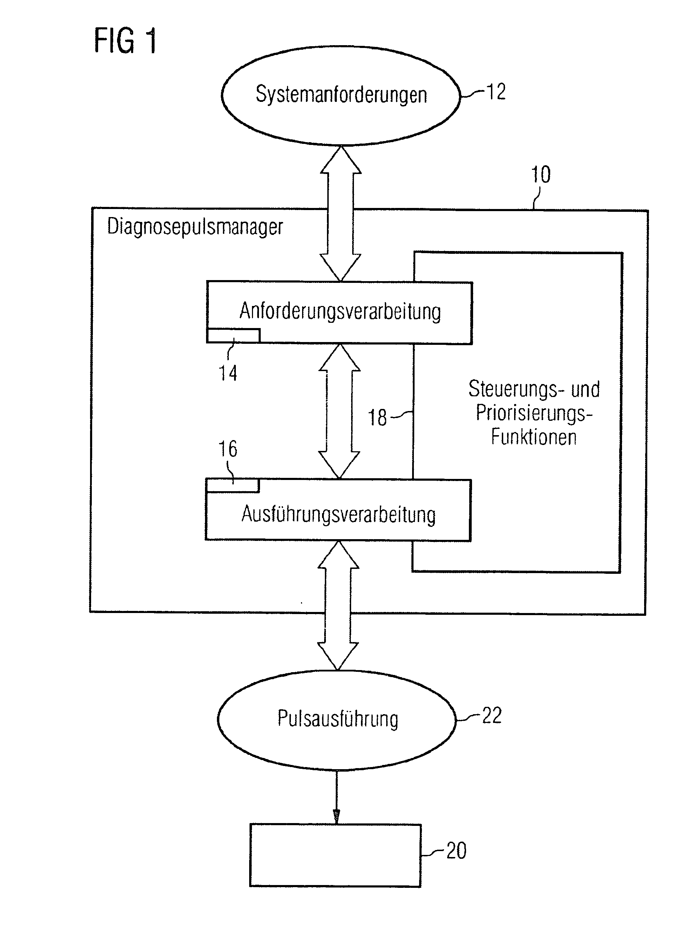

Figur 1 zeigt ein Funktionsblockdiagramm zur Erläuterung der vorliegenden Erfindung. Das in Figur 1 dargestellte Zentralelement ist ein Diagnosepulsmanager 10. Dieser ist auf der einen Seite mit Systemanforderungen 12 konfrontiert und muss auf der anderen Seite für eine Pulsausführung 22 sorgen, die sich auf verschiedene Treiberausgänge 20 bezieht. Der Diagnosepulsmanager 10 bewerkstelligt dies durch eine Anforderungsverarbeitung, die insbesondere ein Diagnosepulsanforderungsregister 14 umfasst, und eine Ausführungsverarbeitung, die insbesondere ein Diagnosepulsausführungsregister 16 umfasst. Zwischen der Anforderungsverarbeitung und der Ausführungsverarbeitung wird durch Steuerungs- und Priorisierungsfunktionen 18 vermittelt, so dass gewährleistet ist, dass den Systemanforderungen 12 bei der Pulsausführung 22 Rechnung getragen wird, insbesondere unter Berücksichtigung verschiedener Kriterien, was nachfolgend anhand verschiedener Beispiele erläutert wird.

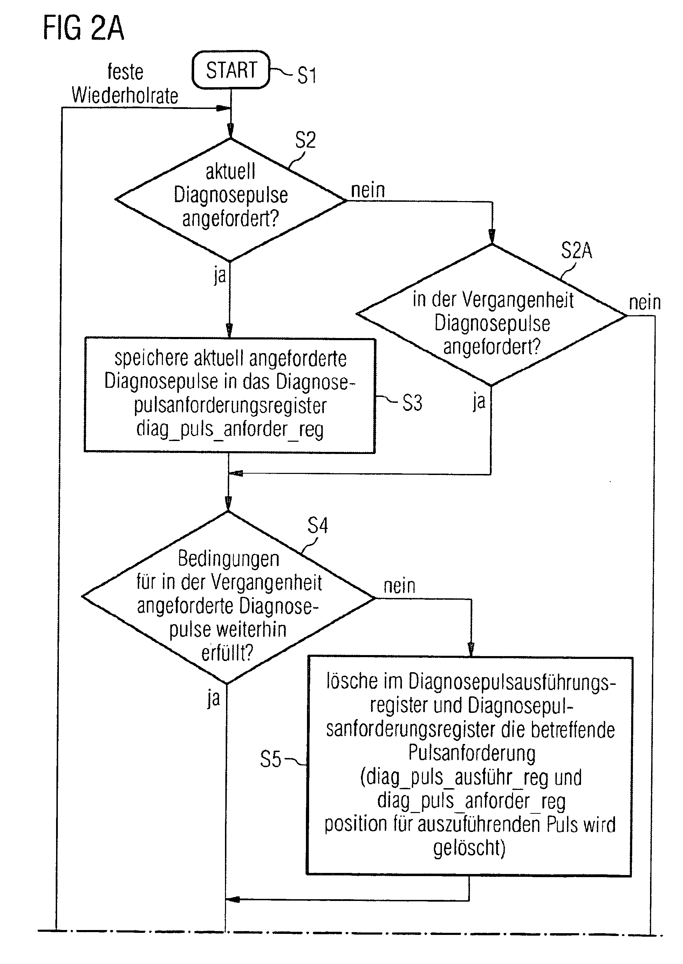

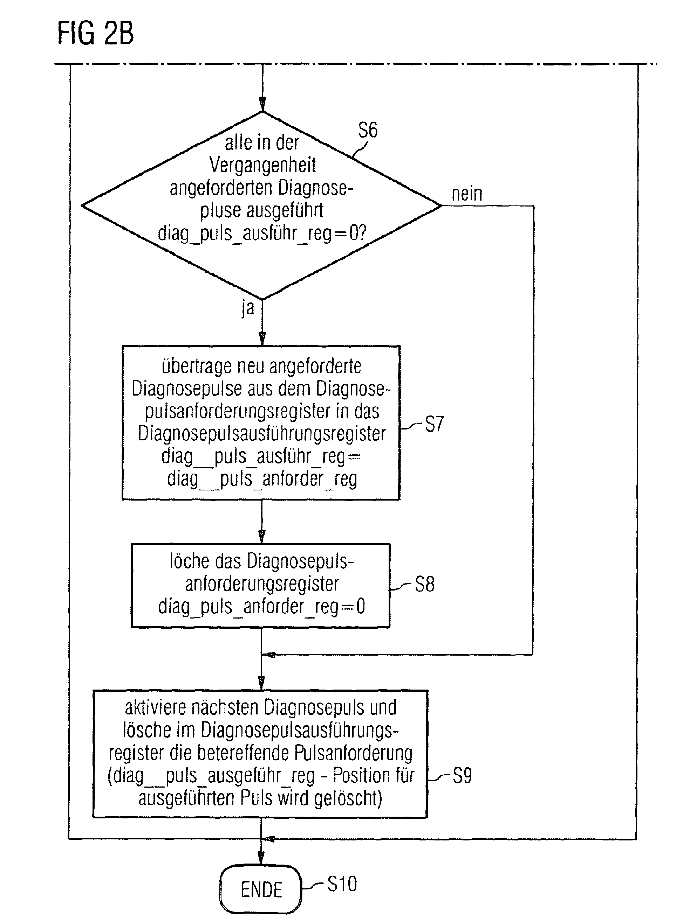

Figur 2 zeigt ein Flussdiagramm zur Erläuterung eines erfindungsgemäßen Verfahrens. Es wird zunächst allgemein ein Ablauf des erfindungsgemäßen Verfahrens erläutert, der nach dem Start des Verfahrens in Schritt S1 mit fester Wiederholrate stattfindet. In Schritt S2 wird geprüft, ob aktuell Diagnosepulse angefordert werden. Ist dies nicht der Fall, so wird in Schritt S2A geprüft, ob in der Vergangenheit Diagnosepulse angefordert wurden. Ist auch dies nicht der Fall, so kehrt der Verfahrensablauf zur Prüfung gemäß Schritt S2 zurück. Wurden in der Vergangenheit jedoch Diagnosepulse angefordert, so geht der Verfahrensablauf von Schritt SA2 zu dem Verfahrensschritt S4 über, der in dem Fall, dass aktuell Diagnosepulse angefordert werden (Schritt S2), über den Verfahrensschritt S3 erreicht wird. In diesem Verfahrensschritt S3 werden die aktuell angeforderten Diagnosepulse in das Diagnosepulsanforderungsregister "diag_puls_anforder_reg" gespeichert.

In Schritt S4 wird nun geprüft, ob die Bedingungen für in der Vergangenheit angeforderte Diagnosepulse weiterhin erfüllt sind. Ist dies nicht der Fall, so wird gemäß Schritt S5 im Diagnosepulsausführungsregister "diag_puls _ausführ_reg" und im Diagnosepulsanforderungs.register die betreffende Pulsanforderung gelöscht. Im Anschluss daran beziehungsweise wenn die Bedingungen für in der Vergangenheit angeforderte Diagnosepulse jedoch weiterhin erfüllt sind, wird in Schritt S6 geprüft, ob alle in der Vergangenheit angeforderten Diagnosepulse bereits ausgeführt sind, das heißt, ob für das Diagnosepulsausführungsregister gilt: diag_puls_ausführ_reg == 0. Ist dies der Fall, so werden in Schritt S7 neu angeforderte Diagnosepulse aus dem Diagnosepulsanforderungsregister in das Diagnosepulsausführungsregister übertragen, das heißt das Diagnosepulsanforderungsregister wird in das Diagnosepulsausführungsregister kopiert (diag_puls_ausführ_reg = diag_puls_anforder_reg). Nachfolgend wird in Schritt S8 das Diagnosepulsanforderungsregister gelöscht (diag_puls_anforder_reg = 0).

Nachfolgend wird in Schritt S9 der nächste Diagnosepuls aktiviert und im Diagnosepulsausführungsregister wird die betreffende Pulsanforderung gelöscht. Schritt S9 kann auch ausgehend von Schritt S6 direkt erreicht werden, wenn nicht alle in der Vergangenheit angeforderten Diagnosepulse bereits ausgeführt sind. In diesem Fall findet die Aktivierung der nächsten Diagnosepulse und das Löschen der entsprechenden Stelle im Diagnosepulsausführungsregister für in der Vergangenheit angeforderte Diagnosepulse statt. Nach Schritt S9 geht der Funktionsablauf wieder zu Schritt S2 über, beziehungsweise er endet in Schritt S10.

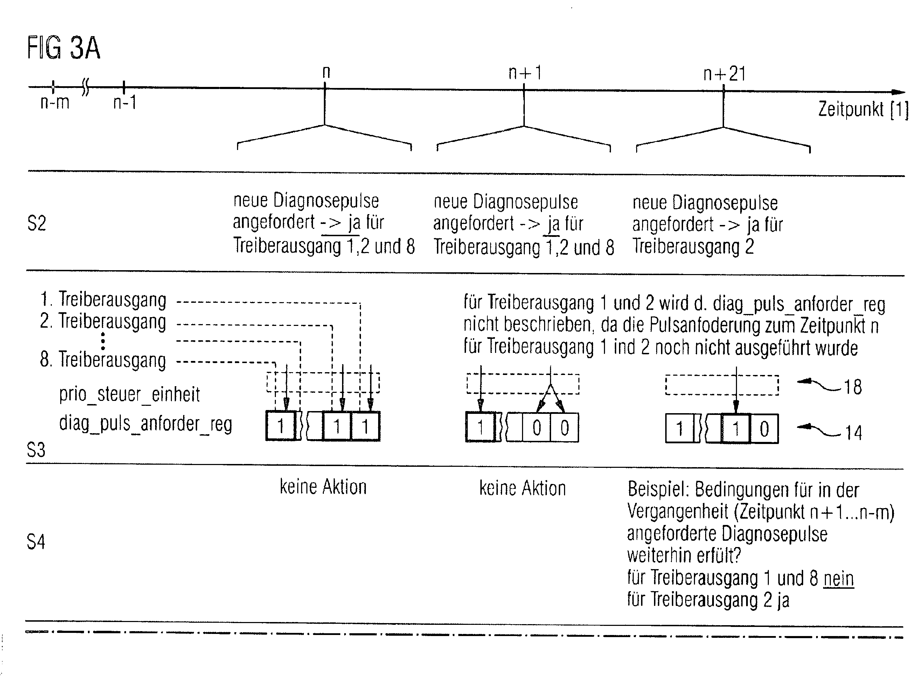

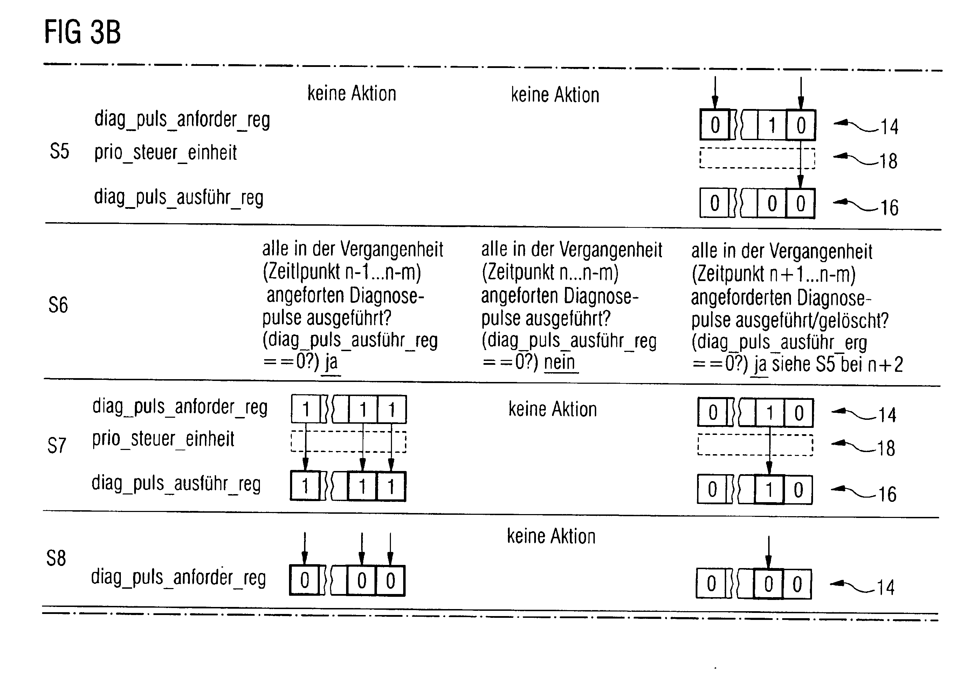

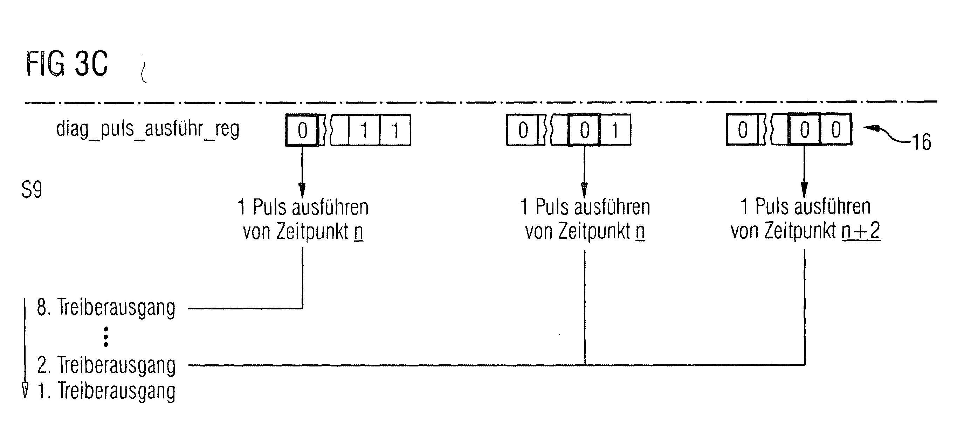

Figur 3 zeigt ein Diagramm zur beispielhaften Erläuterung des Flussdiagramms gemäß Figur 2. Anhand dieses Diagramms werden verschiedene Abläufe bei unterschiedlichen Szenarien von Systemanforderungen erläutert. In Schritt S2 werden zum Zeitpunkt n neue Diagnosepulse angefordert, nämlich für die Treiberausgänge 1, 2 und 8. Folglich wird die in Schritt S2 gemäß Figur 2 gestellte Frage mit "ja" beantwortet, und der Verfahrensablauf geht zu Schritt S3 über.

In Schritt S3 werden unter Vermittlung der Priorisierungs- und Steuereinheit die aktuell angeforderten Pulse im Diagnosepulsanforderungsregister gespeichert. Im beispielhaften Fall werden somit die Registerstellen 1, 2 und 8 auf den Wert 1 gesetzt, wobei das aktive Setzen der Registerstellen im vorliegenden Diagramm gemäß Figur 8 durch Schattierung der Registerstellen gekennzeichnet ist.

Nachfolgend wird in Schritt S4 gefragt, ob die Bedingungen für gegebenenfalls in der Vergangenheit angeforderte Diagnosepulse weiterhin erfüllt sind. Da es im vorliegenden Beispiel keine in der Vergangenheit angeforderten Diagnosepulse gibt, ist die Frage mit "ja" zu beantworten, so dass das Verfahren ohne Aktion in Schritt S5 zu Schritt S6 übergeht. In Schritt S6 wird geprüft, ob gilt: diag_puls_ausführ_reg == 0. Dies bedeutet in dem Fall, dass bereits in der Vergangenheit Diagnosepulse angefordert wurden, dass diese auch bereits ausgeführt wurden. Im vorliegenden Beispiel befindet sich das Diagnosepulsausführungsregister durchgängig im Zustand 0, da dies sein Anfangszustand ist. Auf die Frage gemäß Schritt S6 wird somit mit "ja" geantwortet, so dass in Schritt S7 die neu angeforderten Diagnosepulse aus dem Diagnosepulsanforderungsregister in das Diagnosepulsausführungsregister übertragen werden können. Dies erfolgt unter Vermittlung der Priorisierungs- und Steuereinheit.

Nachfolgend wird in Schritt S8 das Diagnosepulsanforderungsregister gelöscht.

In Schritt S9 wird dann der nächste Diagnosepuls aktiviert, und die entsprechende Pulsanforderung wird im Diagnosepulsausführungsregister gelöscht. Im vorliegenden Beispiel hat die Stelle im Diagnosepulsausführungsregister die höchste Priorität, die dem Treiberausgang mit der höchsten Ordnungszahl zugeordnet ist.

Der Verfahrensablauf kehrt nachfolgend zu Schritt S2 zurück, um auf die zum Zeitpunkt n+1 vorliegenden Systemanforderungen zu reagieren. Im vorliegenden Beispiel werden wiederum neue Diagnosepulse angefordert, nämlich auch hier wieder für die Treiberausgänge 1, 2 und 8. Die Frage in Schritt S2 wird somit mit "ja" beantwortet, und der Verfahrensablauf geht zu Schritt S3 über. Da der Wert für den Treiberausgang 8 im Diagnosepulsausführungsregister zum Zeitpunkt n in Schritt S9 auf 0 gesetzt wurde, wird dieser in Schritt n+1 wieder auf 1 gesetzt, im Gegensatz zu den im Diagnosepulsanforderungsregister den Treiberausgängen 1 und 2 entsprechenden Stellen, da diese im Diagnosepulsausführungsregister nach wie vor auf 1 gesetzt sind.

In Schritt S4 wird nachfolgend geprüft, ob die Bedingungen für in der Vergangenheit angeforderte Diagnosepulse weiterhin erfüllt sind. Da dies der Fall ist - für die Treiberausgänge 1, 2 und 8 werden nach wie vor Diagnosepulse angefordert - wird sogleich zu Schritt S6 übergegangen, in dem geprüft wird, ob alle in der Vergangenheit angeforderten Diagnosepulse ausgeführt wurden. Diese Frage wird zum Zeitpunkt n+1 mit "nein" beantwortet, da die für den ersten Treiberausgang und den zweiten Treiberausgang angeforderten Diagnosepulse noch nicht ausgeführt wurden. Das Verfahren geht folglich zu Schritt S9 über, wo der in Prioritätsreihenfolge nächste Diagnosepuls ausgeführt wird, nämlich der Diagnosepuls für den zweiten Treiberausgang.

Das Verfahren geht nachfolgend wieder zu Schritt S2 über, wo geprüft wird, ob aktuell Diagnosepulse angefordert werden. Diese Frage wird mit "ja" beantwortet, da zum Zeitpunkt n+2 für den Treiberausgang 2 ein Diagnosepuls angefordert wird. Folglich wird in Schritt S3 der aktuell angeforderte Diagnosepuls an der entsprechenden Stelle im Diagnosepulsanforderungsregister gespeichert.

Nachfolgend wird in Schritt S4 geprüft, ob Bedingungen für in der Vergangenheit angeforderte Diagnosepulse weiterhin erfüllt sind. Dies ist nur teilweise der Fall, nämlich für den Treiberausgang 2 und nicht für die Treiberausgänge 1 und 8, so dass die Frage insgesamt mit "nein" beantwortet werden muss. Folglich geht der Verfahrensablauf zu Schritt S5 über, wo im Diagnosepulsausführungsregister und im Diagnosepulsanforderungsregister die entsprechenden Stellen gelöscht werden. Dies betrifft im Diagnosepulsanforderungsregister die Stellen 1 und 8, während im Diagnosepulsausführungsregister aufgrund der bereits stattgefundenen Impulsausführung am achten Treiberausgang nur die dem ersten Treiberausgang entsprechende Stelle auf 0 gesetzt werden muss.

In Schritt S6 wird geprüft, ob alle in der Vergangenheit angeforderten Diagnosepulse ausgeführt wurden. Dies ist der Fall, da das Diagnosepulsausführungsregister vollständig auf 0 gesetzt ist. Das Verfahren geht folglich zu Schritt 57 über und der Zustand des Diagnosepulsanforderungsregisters wird in das Diagnosepulsausführungsregister übertragen.

Nachfolgend wird in Schritt S8 das Diagnosepulsanforderungsregister gelöscht.

In Schritt S9 wird der einzige gemäß Diagnosepulsausführungsregister auszuführende Puls für den zweiten Treiberausgang ausgeführt, und die entsprechende Stelle im Diagnosepulsausführungsregister wird gelöscht.

Ohne dass im Vorangehenden stets darauf hingewiesen wurde, finden die Veränderungen in den Registern häufig unter Vermittlung der Priorisierungs- und Steuerungseinheit statt, was im Diagramm gemäß Figur 3 dadurch veranschaulicht ist, dass die die Beeinflussung der Registerstellen repräsentierenden Pfeile durch die die Priorisierungs- und Steuerungseinheit 18 symbolisierenden mit unterbrochenen Linien gezeichneten Kästen hindurchtreten müssen.

Die Erfindung lässt sich wie folgt zusammenfassen: Es werden ein Verfahren zur Diagnose von Treiberausgängen 20 und ein Diagnosepulsmanager 10 angegeben, die in der Lage sind, einem Treiberausgang 20 einen Puls zuzuführen, um eine Diagnose dieses Treiberausgangs durchzuführen. Da die Systemanforderungen 12 so ausfallen können, dass gleichzeitig mehrere Diagnosepulse angefordert werden, werden ein Diagnosepulsanforderungsregister 14 und ein Diagnosepulsausführungsregister 16 zur Verfügung gestellt, so dass mehrere gleichzeitig bestehende Anforderungen 12 gespeichert werden können. Auf der Grundlage dieser Pufferung von Anforderungen 12 ist es möglich, dass mehrere gespeicherte Pulsanforderungen gemäß vorgegebener Regeln nacheinander berücksichtigt werden können.

## Patentansprüche

1. Verfahren zur Diagnose von Treiberausgängen (20), insbesondere zum Einsatz in einem Kraftfahrzeug, bei dem zum Auslesen eines Diagnoseergebnisses an einem Treiberausgang (20) dem Treiberausgang (20) ein Puls zugeführt wird,
**dadurch gekennzeichnet,**
- **dass** eine für einen Treiberausgang (20) bestehende Anforderung (12) eines Pulses gespeichert wird, wobei mehrere für verschiedene Treiberausgänge gleichzeitig bestehende Anforderungen (12) gespeichert werden, und
- **dass** mehrere gespeicherte Anforderungen (12) gemäß vorgegebenen Regeln nacheinander berücksichtigt werden.

2. Verfahren nach Anspruch 1,
**dadurch gekennzeichnet,**
- **dass** die Anforderungen (12) in einem Diagnosepulsanforderungsregister (14) als binäre Werte gespeichert werden,
- **dass** die in dem Diagnosepulsanforderungsregister (14) gespeicherten Anforderungen (12) in ein Diagnosepulsausführungsregister (16) übertragen werden und
- **dass** das Diagnosepulsanforderungsregister (14) nach dem Übertragen der Anforderungen (12) in das Diagnosepulsausführungsregister (16) gelöscht wird.

3. Verfahren nach Anspruch 2,
**dadurch gekennzeichnet,**
**dass** das Übertragen der Anforderungen (12) von dem Diagnosepulsanforderungsregister (14) in das Diagnosepulsausführungsregister (16) nur dann erfolgt, wenn in dem Diagnosepulsausführungsregister (16) keine Anforderungen (12) gespeichert sind.

4. Verfahren nach Anspruch 2 oder 3,
**dadurch gekennzeichnet,**
**dass** vor dem Übertragen der Anforderungen (12) von dem Diagnosepulsanforderungsregister (14) in das Diagnosepulsausführungsregister (16) in dem Diagnosepulsanforderungsregister (14) nicht mehr gespeicherte Anforderungen (12) ebenfalls in dem Diagnosepulsausführungsregister (16) gelöscht werden.

5. Verfahren nach einem der Ansprüche 2 bis 4,
**dadurch gekennzeichnet,**
**dass** nach dem Berücksichtigen einer in dem Diagnosepulsausführungsregister (16) gespeicherten Anforderung (12) diese Anforderung (12) in dem Diagnosepulsausführungsregister (16) gelöscht wird.

6. Verfahren nach einem der vorhergehenden Ansprüche,
**dadurch gekennzeichnet,**
**dass** die vorgegebenen Regeln auf mindestens einem der folgenden Kriterien beruhen:
- verschiedene Treiberausgänge (20) haben unterschiedliche Priorität, und
- eine einem bestimmten Treiberausgang (20) zugeordnete Anforderung (12) darf berücksichtigt werden.

7. Verfahren nach Anspruch 6,
**dadurch gekennzeichnet,**
**dass** die Prioritäten der Treiberausgänge (20) durch Konfiguration einer Steuerungs- und Priorisierungseinheit (18) festgelegt werden.

8. Verfahren nach Anspruch 6 oder 7,
**dadurch gekennzeichnet,**
**dass** sich die Prioritäten der Treiberausgänge (20) dynamisch in Abhängigkeit von Betriebszuständen des Kraftfahrzeugs ändern.

9. Diagnosepulsmanager (10) zum Zuführen von Pulsen zu Treiberausgängen (20) in Abhängigkeit von Systemanforderungen (12), insbesondere zum Einsatz in einem Kraftfahrzeug, um an Treiberausgängen (20) Diagnoseergebnisse auszulesen,
**dadurch gekennzeichnet,**
- **dass** ein Diagnosepulsanforderungsregister (14) zum Speichern einer für einen Treiberausgang (20) bestehenden Anforderung (12) eines Pulses vorgesehen ist, wobei mehrere für verschiedene Treiberausgänge gleichzeitig bestehende Anforderungen (12) gespeichert werden, und
- **dass** der Diagnosepulsmanager geeignet ist, mehrere gespeicherte Anforderungen (12) gemäß vorgegebenen Regeln nacheinander zu berücksichtigen.

10. Diagnosepulsmanager (10) nach Anspruch 9,
**dadurch gekennzeichnet,**
- **dass** die Anforderungen (12) in dem Diagnosepulsanforderungsregister (14) als binäre Werte gespeichert werden,
- **dass** die in dem Diagnosepulsanforderungsregister (14) gespeicherten Anforderungen (12) in ein Diagnosepulsausführungsregister (16) übertragen werden und
- **dass** der Diagnosepulsmanager geeignet ist, das Diagnosepulsanforderungsregister (14) nach dem Übertragen der Anforderungen (12) in das Diagnosepulsausführungsregister (16) zu löschen.

11. Diagnosepulsmanager (10) nach Anspruch 10,
**dadurch gekennzeichnet,**
- **dass** der Diagnosepulsmanager geeignet ist, das Übertragen der Anforderungen (12) von dem Diagnosepulsanforderungsregister (14) in das Diagnosepulsausführungsregister (16) nur dann zu veranlassen, wenn in dem Diagnosepulsausführungsregister (16) keine Anforderungen (12) gespeichert sind.

12. Diagnosepulsmanager (10) nach Anspruch 10 oder 11,
**dadurch gekennzeichnet,**
**dass** der Diagnosepulsmanager geeignet ist, vor dem Übertragen der Anforderungen (12) von dem Diagnosepulsanforderungsregister (14) in das Diagnosepulsausführungsregister (16) in dem Diagnosepulsanforderungsregister (14) nicht mehr gespeicherte Anforderungen (12) ebenfalls in dem Diagnosepulsausführungsregister (16) zu löschen.

13. Diagnosepulsmanager (10) nach einem der Ansprüche 10 bis 12,
**dadurch gekennzeichnet,**
**dass** der Diagnosepulsmanager geeignet ist, nach dem Berücksichtigen einer in dem Diagnosepulsausführungsregister (16) gespeicherten Anforderung (12) diese Anforderung (12) in dem Diagnosepulsausführungsregister (16) zu löschen.

14. Diagnosepulsmanager (10) nach einem der Ansprüche 9 bis 13,
**dadurch gekennzeichnet,**
**dass** die vorgegebenen Regeln auf mindestens einem der folgenden Kriterien beruhen:
- verschiedene Treiberausgänge (20) haben unterschiedliche Priorität und
- eine einem bestimmten Treiberausgang (20) zugeordnete Anforderung (12) darf berücksichtigt werden.

15. Diagnosepulsmanager (10) nach Anspruch 14,
**dadurch gekennzeichnet,**
**dass** der Diagnosepulsmanager geeignet ist, die Prioritäten der Treiberausgänge (20) durch Konfiguration einer Steuerungs- und Priorisierungseinheit (18) festzulegen.

16. Diagnosepulsmanager (10) nach Anspruch 14 oder 15,
**dadurch gekennzeichnet,**
**dass** der Diagnosepulsmanager geeignet ist, die Prioritäten der Treiberausgänge (20) dynamisch in Abhängigkeit von Betriebszuständen des Kraftfahrzeugs zu ändern.

## Claims

1. Method for diagnosis of driver outputs (20), especially for use in a motor vehicle, in which, for reading out a diagnosis result at a driver output (20), a pulse is fed to the driver output (20),
**characterised in that**,
- a requirement (12) of a pulse existing for a driver output (20) is stored, with especially a plurality of simultaneously existing requirements (12) being stored, and
- a plurality of stored requirements (12) being successively taken into account in accordance with predetermined rules.

2. Method in accordance with claim 1,
**characterised in that**,
- the requirements (12) are stored in a diagnosis pulse requirement register (14) as binary values,
- the requirements (12) stored in the diagnosis pulse requirement register (14) are transmitted into a diagnosis pulse execution register (16) and
- the diagnosis pulse requirement register (14) can be erased after the transmission of the requirements (12) into the diagnosis pulse execution register (16).

3. Method in accordance with claim 2,
**characterised in that**,
the requirements (12) are transmitted from the diagnosis pulse requirement register (14) into the diagnosis pulse execution register (16) only if no requirements (12) are stored in the diagnosis pulse execution register (16).

4. Method in accordance with Claim 2 or 3,
**characterised in that**
before the requirements (12) are transmitted from the diagnosis pulse requirement register (14) into the diagnosis pulse execution register (16), requirements (12) which are no longer stored in the diagnosis pulse requirement register (14) are also deleted from the diagnosis pulse execution register (16).

5. Method in accordance with one of the claims 2 to 4,
**characterised in that**
after a requirement (12) stored in the diagnosis pulse execution register (16) has been taken into account, this requirement (12) is deleted in the diagnosis pulse execution register (16).

6. Method in accordance with one of the previous claims
**characterised in that**
the predetermined rules are based on at least one of the following criteria:
- different driver outputs (20) have a different priority, and
- a requirement (12) assigned to a specific driver output (20) may be taken into consideration.

7. Method in accordance with claim 6,
**characterised in that**
the priorities of the driver outputs (20) are defined by configuration of a control and prioritization unit (18).

8. Method in accordance with Claim 6 or 7,
**characterised in that**
the priorities of the driver outputs (20) change dynamically depending on operating states of the motor vehicle.

9. Diagnosis pulse manager (10) for feeding pulses to driver outputs (20) depending on system requirements (12), especially for use in a motor vehicle, in order to read out diagnosis results at driver outputs (20),
**characterised in that**
- a diagnosis pulse requirement register (14) is provided for storing an existing requirement (12) of a pulse for a driver output (20), with a plurality of simultaneously existing requirements (12) being stored, and
- the diagnosis pulse manager is suitable for taking into account a number of stored requirements (12) successively in accordance with predetermined rules.

10. Diagnosis pulse manager (10) in accordance with claim 9,
**characterised in that**
- the requirements (12) are stored in the diagnosis pulse requirement register (14) as binary values,
- the requirements (12) stored in the diagnosis pulse requirement register (14) are transmitted into a diagnosis pulse execution register (16) and
- the diagnosis pulse manager is suitable for deleting the diagnosis pulse requirement register (14) after the requirements (12) have been transferred into the diagnosis pulse execution register (16).

11. Diagnosis pulse manager (10) in accordance with claim 10,
**characterised in that**
- the diagnosis pulse manager is suitable for initiating the transfer of the requirements (12) from the diagnosis pulse requirement register (14) into the diagnosis pulse execution register (16) only if no requirements (12) are stored in the diagnosis pulse execution register (16).

12. Diagnosis pulse manager (10) in accordance with claim 10 or 11,
**characterised in that**
the diagnosis pulse manager is suitable, before the requirements (12) are transmitted from the diagnosis pulse requirement register (14) into the diagnosis pulse execution register (16), for deleting requirements (12) which are no longer stored in the diagnosis pulse requirement register (14) from the diagnosis pulse execution register (16).

13. Diagnosis pulse manager (10) in accordance with one of the claims 10 to 12,
**characterised in that**
the diagnosis pulse manager is suitable, after a requirement (120 stored in the diagnosis pulse execution register (16) has been taken into account, for deleting this requirement (12) in the diagnosis pulse execution register (16).

14. Diagnosis pulse manager (10) in accordance with one of the claims 9 to 13,
**characterised in that**
the predetermined rules are based on at least one of the following criteria:
- different driver outputs (20) have a different priority, and
- a requirement (12) assigned to a specific driver output (20) may be taken into consideration.

15. Diagnosis pulse manager (10) in accordance with claim 14,
**characterised in that**
the diagnosis pulse manager is suitable for defining the priorities of the driver outputs (20) by configuration of a control and prioritization unit (18).

16. Diagnosis pulse manager (10) in accordance with claim 14 or 15,
**characterised in that**
the diagnosis pulse manager is suitable for changing the priorities of the driver outputs (20) dynamically depending on operating states of the motor vehicle.

## Revendications

1. Procédé de diagnostic de sorties de circuit d'attaque (20), en particulier pour mise en oeuvre dans un véhicule automobile, dans lequel, aux fins d'extraire un résultat de diagnostic au niveau d'une sortie de circuit d'attaque (20), une impulsion est envoyée sur la sortie de circuit d'attaque (20), **caractérisé en ce que**
- une demande (12) d'impulsion existant pour une sortie de circuit d'attaque (20) est mise en mémoire, plusieurs demandes (12) qui coexistent pour différentes sorties de circuit d'attaque étant mises en mémoire, et
- plusieurs demandes (12) mises en mémoire étant prises en compte successivement selon des règles prédéterminées.

2. Procédé selon la revendication 1, **caractérisé en ce que**
- les demandes (12) sont mises en mémoire sous la forme de valeurs binaires dans un registre de demandes d'impulsions de diagnostic (14),
- les demandes (12) stockées dans le registre de demandes d'impulsions de diagnostic (14) sont transférées vers un registre de réalisation d'impulsions de diagnostic (16) et
- après le transfert des demandes (12) vers le registre de réalisation d'impulsions de diagnostic (16), le registre de demandes d'impulsions de diagnostic (14) est effacé.

3. Procédé selon la revendication 2, **caractérisé en ce que** le transfert des demandes (12) du registre de demandes d'impulsions de diagnostic (14) vers le registre de réalisation d'impulsions de diagnostic (16) n'a lieu que si aucune demande (12) n'est stockée dans le registre de réalisation d'impulsions de diagnostic (16).

4. Procédé selon la revendication 2 ou 3, **caractérisé en ce que**, avant le transfert des demandes (12) du registre de demandes d'impulsions de diagnostic (14) vers le registre de réalisation d'impulsions de diagnostic (16), des demandes (12) qui ne sont plus stockées dans le registre de demandes d'impulsions de diagnostic (14) sont également effacées dans le registre de réalisation d'impulsions de diagnostic (16).

5. Procédé selon l'une des revendications 2 à 4, **caractérisé en ce que**, après la prise en compte d'une demande (12) stockée dans le registre de réalisation d'impulsions de diagnostic (16), cette demande (12) est effacée dans le registre de réalisation d'impulsions de diagnostic (16).

6. Procédé selon l'une des revendications précédentes, **caractérisé en ce que** les règles prédéterminées reposent sur au moins l'un des critères suivants:
- différentes sorties de circuit d'attaque (20) ont une priorité différente et
- une demande (12) affectée à une sortie de circuit d'attaque (20) déterminée peut être prise en compte.

7. Procédé selon la revendication 6, **caractérisé en ce que** les priorités des sorties de circuit d'attaque (20) sont déterminées par configuration d'une unité de commande et de priorisation (18).

8. Procédé selon la revendication 6 ou 7, **caractérisé en ce que** les priorités des sorties de circuit d'attaque (20) se modifient dynamiquement en fonction d'états de fonctionnement du véhicule automobile.

9. Gestionnaire d'impulsions de diagnostic (10) destiné à envoyer des impulsions sur des sorties de circuit d'attaque (20) en fonction de demandes du système (12), en particulier pour mise en oeuvre dans un véhicule automobile, pour extraire des résultats de diagnostic au niveau de sorties de circuit d'attaque (20), **caractérisé en ce que**
- un registre de demandes d'impulsions de diagnostic (14) est prévu pour mettre en mémoire une demande (12) d'impulsion existant pour une sortie de circuit d'attaque (20), plusieurs demandes (12) qui coexistent pour différentes sorties de circuit d'attaque étant mises en mémoire, et
- le gestionnaire d'impulsions de diagnostic étant apte à prendre en compte, successivement et selon des règles prédéterminées, plusieurs demandes (12) mises en mémoire.

10. Gestionnaire d'impulsions de diagnostic (10) selon la revendication 9, **caractérisé en ce que**
- les demandes (12) sont mises en mémoire sous la forme de valeurs binaires dans le registre de demandes d'impulsions de diagnostic (14),
- les demandes (12) stockées dans le registre de demandes d'impulsions de diagnostic (14) sont transférées vers un registre de réalisation d'impulsions de diagnostic (16) et
- le gestionnaire d'impulsions de diagnostic est apte à effacer le registre de demandes d'impulsions de diagnostic (14) après le transfert des demandes (12) vers le registre de réalisation d'impulsions de diagnostic (16).

11. Gestionnaire d'impulsions de diagnostic (10) selon la revendication 10, **caractérisé en ce que** le gestionnaire d'impulsions de diagnostic est apte à ne provoquer le transfert des demandes (12) du registre de demandes d'impulsions de diagnostic (14) vers le registre de réalisation d'impulsions de diagnostic (16) que si aucune demande (12) n'est stockée dans le registre de réalisation d'impulsions de diagnostic (16).

12. Gestionnaire d'impulsions de diagnostic (10) selon la revendication 10 ou 11, **caractérisé en ce que** le gestionnaire d'impulsions de diagnostic, avant le transfert des demandes (12) du registre de demandes d'impulsions de diagnostic (14) vers le registre de réalisation d'impulsions de diagnostic (16), est apte à effacer également, dans le registre de réalisation d'impulsions de diagnostic (16), des demandes (12) qui ne sont plus stockées dans le registre de demandes d'impulsions de diagnostic (14).

13. Gestionnaire d'impulsions de diagnostic (10) selon l'une des revendications 10 à 12, **caractérisé en ce que** le gestionnaire d'impulsions de diagnostic, après la prise en compte d'une demande (12) stockée dans le registre de réalisation d'impulsions de diagnostic (16), est apte à effacer cette demande (12) dans le registre de réalisation d'impulsions de diagnostic (16).

14. Gestionnaire d'impulsions de diagnostic (10) selon l'une des revendications 9 à 13, **caractérisé en ce que** les règles prédéterminées reposent sur au moins l'un des critères suivants:
- différentes sorties de circuit d'attaque (20) ont une priorité différente et
- une demande (12) affectée à une sortie de circuit d'attaque (20) déterminée peut être prise en compte.

15. Gestionnaire d'impulsions de diagnostic (10) selon la revendication 14, **caractérisé en ce que** le gestionnaire d'impulsions de diagnostic est apte à déterminer les priorités des sorties de circuit d'attaque (20) par configuration d'une unité de commande et de priorisation (18).

16. Gestionnaire d'impulsions de diagnostic (10) selon la revendication 14 ou 15, **caractérisé en ce que** le gestionnaire d'impulsions de diagnostic est apte à modifier les priorités des sorties de circuit d'attaque (20) dynamiquement en fonction d'états de fonctionnement du véhicule automobile.
